(19) Europäisches Patentamt
European Patent Office
Office européen des brevets

(11) EP 2 878 620 A1

(12) # EUROPÄISCHE PATENTANMELDUNG

(43) Veröffentlichungstag:
**03.06.2015 Patentblatt 2015/23**

(51) Int Cl.:
***C08K 3/34*** *(2006.01)* ***C08L 67/00*** *(2006.01)*
***H01L 33/64*** *(2010.01)*

(21) Anmeldenummer: **14194155.9**

(22) Anmeldetag: **20.11.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **02.12.2013 EP 13195325**

(71) Anmelder: **LANXESS Deutschland GmbH
50569 Köln (DE)**

(72) Erfinder:
- **Immel, Timo
41539 Dormagen (DE)**
- **Endtner, Jochen
50679 Köln (DE)**
- **Bienmüller, Matthias
47803 Krefeld (DE)**
- **Benighaus, Tobias
48145 Münster (DE)**
- **Plutowski, Ulrich
41539 Dormagen (DE)**

(54) **Polyester Zusammensetzungen**

(57) Die vorliegende Erfindung betrifft Zusammensetzungen, insbesondere thermoplastische Formmassen, auf Basis von Polyestern und triklin pinakoidalem Aluminiumsilikat, deren Herstellung, sowie die Verwendung dieser Zusammensetzungen als Formmassen für den Spritzguss oder in der Extrusion zur Herstellung elektrisch isolierender, thermisch leitfähiger Erzeugnisse bevorzugt zur Herstellung von Kühlkörpern, insbesondere von Kühlkörpern für Licht emittierende Dioden (LEDs).

EP 2 878 620 A1

## Beschreibung

## Polyester Zusammensetzungen

Die vorliegende Erfindung betrifft Zusammensetzungen, insbesondere thermoplastische Formmassen, auf Basis von Polyestern und triklin pinakoidalem Aluminiumsilikat, deren Herstellung, sowie die Verwendung dieser Zusammensetzungen als Formmassen für den Spritzguss oder in der Extrusion zur Herstellung elektrisch isolierender, thermisch leitfähiger Erzeugnisse bevorzugt zur Herstellung von Kühlkörpern, insbesondere von Kühlkörpern für Licht emittierende Dioden (LEDs).

## Stand der Technik

Thermoplastische Polymere werden wegen ihrer guten elektrisch isolierenden Eigenschaften für zahlreiche Anwendungen in der Elektroindustrie eingesetzt. Sie wirken aufgrund ihrer geringen Wärmeleitfähigkeit aber auch thermisch isolierend, was beim Einsatz für elektrische Bauteile dann ein Problem darstellt, wenn relativ viel Wärme entsteht, die abgeführt werden muss. So wird beispielsweise bei LEDs nur ein Anteil im Bereich von etwa 20 bis 30% der aufgenommenen elektrischen Energie in Licht umgewandelt, der Rest fällt als Verlustwärme an. Gegenüber Leuchten mit herkommlichen Lampen ist die Ableitung dieser Verlustwärme sehr viel schwieriger. Einerseits muss die Temperatur der LEDs möglichst niedrig gehalten werden, weil sonst der Wirkungsgrad und die Lebensdauer beeinträchtigt werden. Andererseits ermöglichen LEDs auch eine besonders kleine Bauweise und strahlen so gut wie keine Wärme ab, so dass die Wärmeabfuhr zunächst vor allem durch Wärmeleitung erfolgen muss.

Heute werden zur Entwärmung von LEDs typischerweise metallische Kühlkörper, meist aus Aluminium oder Kupfer eingesetzt. Nachteilig an diesen Kühlkörpern ist zum einen die hohe spezifische Dichte der metallischen Werkstoffe und das Metall-bedingte zwangsläufig hohe Bauteilgewicht. Des Weiteren ist die elektrische Leitfähigkeit des Metalls und die damit einhergehende Gefahr eines Kurzschlusses von Nachteil. Eine Lösung hierfür bieten elektrisch isolierende Kühlkörper aus wärmeleitenden Kunststoffen.

Die Verwendung wärmeleitender Kunststoffe als Kühlkörper zur Entwärmung von elektronischen Bauteilen (DE 10 2007 057 533 A1) und insbesondere auch deren Verwendung bei der Entwärmung von LEDs (DE 10 2011 077 668 A1 und US2012/0307501 A1) ist bekannt.

Polymere sind von Natur aus nur schlecht wärmeleitfähig. Um eine beispielsweise für die Verwendung in LED-Kühlkörpern nötige Wärmeleitfähigkeit zu erreichen, werden den für die Herstellung von Kühlkörpern einzusetzenden Polymer-basierten Formmassen wärmeleitfähige Additive zugesetzt.

In JP 2007 016093 A wird eine Zusammensetzung aus thermoplastischen Polymeren und 1-50 Gew.- % Graphit mit verbesserter thermischer Leitfähigkeit von 1,6 W/mK beschrieben.

Insbesondere für die Verwendung in LED Kühlkörpern beschreibt US 2012/0319031 A1 die Verwendung von thermoplastischen Formmassen mit 10 bis 70 Gew.-% Graphit.

Durch die Verwendung von Graphit in den thermoplastischen Polymeren wird jedoch die Eigenschaft des daraus resultierenden Kunststoffes als elektrischer Isolator deutlich beeinträchtigt. Um diesen Nachteil zu umgehen, werden in der US 2012/0319031 A1 wiederum anorganische Additive zur Verbesserung der Wärmeleitfähigkeit zugegeben.

In DE 102 60 098 A1 und WO 08/043682 A1 wird gezeigt, dass thermoplastische Polyester durch Zusatz von Aluminiumoxid elektrisch isolierend und wärmeleitfähig sind. Als weitere Zusatzstoffe werden niedermolekulare und polymere organische Verbindungen aufgeführt.

Allerdings führt der Einsatz von Aluminiumoxid in der Verarbeitung von Polyester Compounds zu einer verstärkten Abnutzung der eingesetzten Geräte infolge der Härte des Aluminiumoxids. Im Falle der Extrusion Aluminiumoxid-basierter Formmassen sind besonders Schnecke, Schneckengehäuse und Düse von verstärkter Abnutzung betroffen. Bei einer Verarbeitung im Spritzgussprozess wird zusätzlich die Abnutzung der Spritzgussform deutlich erhöht.

Eine Lösung des durch Aluminiumoxid verursachten Problems der verstärkten Abnutzung an einzusetzenden Geräten zeigt EP 2 078 736 A1. Hier wird die Verwendung thermoplastischer Formmassen, bevorzugt auf Basis von Polyestern, mit Bornitrid als wärmeleitfähigem Additiv beschrieben. Allerdings ist die Wärmeleitfähigkeit von Bornitrid aufgrund der Anisotrophie von Bornitrid richtungsabhängig. Hohe Wärmeleitfähigkeiten von mehr als 2 W/mK werden typischer Weise nur in Spritzrichtung erreicht. Des Weiteren erschwert die Anisotropie des Bornitrids die Simulation der Wärmeleitfähigkeit im Bauteil enorm, da die Ausrichtung der Füllstoffteilchen in der abgekühlten Formmasse mit simuliert werden muss.

US-A 4133797 beschreibt den Einsatz von Feldspat-haltigem, wasserfreiem Aluminiumsilikat in thermoplastischen Formmassen auf Basis eines Gemisches von elastomeren Polymeren und einem Polyolefin zur Erzielung u.a. einer verbesserten / hohen Wärmeformbeständigkeit (high heat distortion).

Die deutsche Patentschrift Nr. 596365 betrifft ein Verfahren zur Herstellung feuerfester jedoch thermisch leitfähiger Erzeugnisse, wobei das feuerfeste geschmolzene Material aus Aluminiumsilikat besteht.

DE 10 2011 077 668 A1 beschreibt Leuchten auf Basis eines thermischem Koppelelements aus wärmeleitfähigem Kunststoff, wobei als wärmeleitender Füllstoff Aluminiumoxid, Aluminium, Kupfer, Bornitrid oder Kohlenstoff in Form von Graphit oder Nanoröhrchen eingesetzt wird.

Aufgabe der vorliegenden Erfindung war die Bereitstellung thermoplastischer Formmassen auf Basis von Polyestern zur Herstellung elektrisch isolierender, thermisch leitfähiger Erzeugnisse bevorzugt von Kühlkörpern, insbesondere von Kühlkörpern für Licht emittierende Dioden (LEDs). Diese sollen eine hohe isotrope Wärmeleitfähigkeit und insbesondere eine hohe Wärmeleitfähigkeit auch orthogonal zur Spritzrichtung bei gleichzeitig guten mechanischen Eigenschaften aufweisen. Des Weiteren sollen die oben genannten Nachteile, die mit dem Einsatz von Aluminiumoxid oder Graphit einhergehen, vermieden werden.

Überraschenderweise wurde gefunden, dass thermoplastische Formmassen auf Basis von Polyestern die Aluminiumsilikat mit triklin-pinakoidaler Kristallstruktur in Form des Minerals Kyanit enthalten, sich durch ihre hohe Wärmeleitfähigkeit auch orthogonal zur Spritzrichtung und durch gute mechanische Eigenschaften hervorragend zur Herstellung elektrisch isolierender, thermisch leitfähiger Erzeugnisse, bevorzugt von Kühlkörpern, insbesondere von Kühlkörpern für Licht emittierende Dioden (LEDs), eignen.

## Erfindung

Lösung der Aufgabe und somit Gegenstand der Erfindung sind deshalb Zusammensetzungen, enthaltend

a) 15 bis 70 Gew.-% wenigstens eines Polyesters,

b) 29 bis 84 Gew.-% Aluminiumsilikat und gegebenenfalls

c) 0,01 bis 15 Gew.-% Talkum, wobei die Summe aller Gewichtsprozente stets 100 ergibt.

Bevorzugter Gegenstand der vorliegenden Erfindung sind Zusammensetzungen, insbesondere thermoplastische Formmassen, enthaltend

a) 15 bis 70 Gew.-%, bevorzugt 15 bis 50 Gew.-%, besonders bevorzugt 20 bis 40 Gew.-%, wenigstens eines Polyesters, bevorzugt PBT, PET oder PCT oder Blends aus beliebigen Kombinationen dieser, besonders bevorzugt Blends aus PBT und PET worin der Anteil an PET bezogen auf die Summe aller enthaltenen Polyester im Bereich von 50 bis 99,9 Gew-% liegt, und

b) 30 bis 85 Gew.-% triklin pinakoidales Aluminiumsilikat, bevorzugt 45 bis 80 Gew.-% triklin pinakoidales Aluminiumsilikat, besonders bevorzugt 55 bis 75 Gew.-% triklin pinakoidales Aluminiumsilikat, wobei die Summe aller Gewichtsprozente 100 ergibt.

Zur Klarstellung sei angemerkt, dass vom Rahmen der vorliegenden Erfindung alle nachfolgend aufgeführten allgemeinen oder in Vorzugsbereichen genannten Definitionen und Parameter in beliebigen Kombinationen umfasst sind. Sofern nicht anders angegeben beziehen sich alle Angaben auf Raumtemperatur (RT) = 23 + / - 2 °C und auf Normaldruck 1 bar.

Ferner sei zur Klarstellung angemerkt, dass die Zusammensetzungen in bevorzugter Ausführungsform Mischungen der Komponenten a) und b) sowie aus diesen Mischungen mittels Umarbeitungsverfahren, bevorzugt mittels wenigstens eines Misch- oder Knetapparats, herzustellende thermoplastische Formmassen aber auch aus diesen wiederum, insbesondere durch Extrusion oder Spritzguss, herzustellende Erzeugnisse sein können.

Die Zubereitung der erfindungsgemäßen Zusammensetzungen für eine weitere Nutzung erfolgt durch Mischen der als Edukte einzusetzenden Komponente a), b) und c) bzw. a) und b) in wenigstens einem Mischwerkzeug. Hierdurch werden als Zwischenprodukte, auf den erfindungsgemäßen Zusammensetzungen basierende, Formmassen erhalten. Diese Formmassen - auch als thermoplastische Formmassen bezeichnet - können entweder ausschließlich aus den Komponenten a), b) und c) bzw. a) und b) bestehen, oder aber zusätzlich zu den Komponenten a), b) und c) bzw. a) und b) noch weitere Komponenten enthalten. In diesem Fall sind die Komponenten a), b) und c) bzw. a) und b) im Rahmen der angegebenen Mengenbereiche so zu variieren, dass die Summe aller Gewichtsprozente stets 100 ergibt.

Im Falle thermoplastischer Formmassen und daraus herzustellender Erzeugnisse liegt der Anteil der erfindungsgemäßen Zusammensetzungen in diesen bevorzugt im Bereich von 50 bis 100 Gew,-% vor, wobei es sich bei den übrigen Bestandteilen um Zusatzstoffe handelt, die der Fachmann entsprechend dem späteren Einsatz der Erzeugnisse auswählt, bevorzugt aus wenigstens einer der im Folgenden definierten Komponenten c) bis h). Gegenstand der Erfindung sind bevorzugt also einerseits Zusammensetzungen, insbesondere thermoplastische Formmassen, enthaltend

a) 15 bis 70 Gew.-%, bevorzugt 15 bis 50 Gew.-%, besonders bevorzugt 20 bis 40 Gew.-%, wenigstens eines Polyesters, bevorzugt PBT, PET oder PCT oder Blends aus beliebigen Kombinationen dieser, besonders bevorzugt Blends aus PBT und PET worin der Anteil an PET bezogen auf die Summe aller enthaltenen Polyester im Bereich von 50 bis 99,9 Gew-% liegt und

b) 30 bis 85 Gew.-% triklin pinakoidales Aluminiumsilikat, bevorzugt 45 bis 80 Gew.-% triklin pinakoidales Aluminiumsilikat, besonders bevorzugt 55 bis 75 Gew.-% triklin pinakoidales Aluminiumsilikat, wobei die Mengen der Komponenten a) und b) in der Weise zu kombinieren sind, dass die Summe aller Gewichtsprozente 100 ergibt und diese Zusammensetzungen weitere Zusatzsstoffe gemäß der Komponenten c) bis h) enthalten können.

Gegenstand der Erfindung sind bevorzugt andererseits Zusammensetzungen, insbesondere thermoplastische Formmassen, enthaltend

a) 15 bis 70 Gew.-%, bevorzugt 15 bis 50 Gew.-%, besonders bevorzugt 20 bis 40 Gew.-%, wenigstens eines Polyesters, bevorzugt PBT, PET oder PCT oder Blends aus beliebigen Kombinationen dieser, besonders bevorzugt Blends aus PBT und PET worin der Anteil an PET bezogen auf die Summe aller enthaltenen Polyester im Bereich von 50 bis 99,9 Gew-% liegt,

b) 29 bis 84 Gew.-% triklin pinakoidales Aluminiumsilikat, bevorzugt 45 bis 80 Gew.-% triklin pinakoidales Aluminiumsilikat, besonders bevorzugt 55 bis 75 Gew.-% triklin pinakoidales Aluminiumsilikat, und

c) 1 bis 15 Gew.-%, bevorzugt 0,01 bis 10 Gew.-%, besonders bevorzugt 0,01 bis 5 Gew.-% Talkum, bevorzugt mikrokristallines Talkum, wobei die Menge wenigstens einer der Komponenten a) und b) in der Weise zu reduzieren ist, dass die Summe aller Gewichtsprozente 100 ergibt und auch diese Zusammensetzungen weitere Zusatzstoffe der Komponenten d) bis h) enthalten können.

Gute mechanische Eigenschaften von aus den erfindungsgemäßen Zusammensetzungen bzw. den daraus herzustellenden thermoplastischen Formmassen wiederum herzustellenden Erzeugnissen zeichnen sich durch hohe Werte bei der Izod Schlagzähigkeit und gleichzeitig hohen Werten oder zumindest Beibehaltung der Eigenschaften in Bezug auf Randfaserdehnung gegenüber dem Stand der Technik aus.

Die Schlagzähigkeit beschreibt die Fähigkeit eines Werkstoffes Stoßenergie und Schlagenergie zu absorbieren ohne zu brechen. Die Prüfung der Izod Schlagzähigkeit nach ISO 180 ist eine Standard-Methode zur Bestimmung der Schlagzähigkeit von Materialien. Hierbei wird ein Arm zunächst in einer bestimmten Höhe gehalten (= konstante potentielle Energie) und schließlich freigegeben. Der Arm trifft auf die Probe wobei diese bricht. Von der Energie, die durch die Probe absorbiert wird, wird die Aufprallenergie bestimmt. Die Schlagzähigkeit wird berechnet als das Verhältnis aus Schlagarbeit und Probekörperquerschnitt (Maßeinheit $kJ/m^2$). Die Schlagzähgikeit wurde im Rahmen der vorliegenden Erfindung in Analogie zur ISO 180-1 U bei 23°C bestimmt.

Die Randfaserdehnung wird im Rahmen der vorliegenden Erfindung im Kurzzeit-Biegeversuch in Analogie zur ISO 178 bestimmt. Hierzu werden balkenförmige Probekörper vorzugsweise mit den Abmessungen 80 mm · 10 mm · 4 mm an den Enden auf zwei Aufleger gelegt und in der Mitte mit einem Biegestempel belastet. Aus den ermittelten Kräften und Durchbiegungen werden die Kennwerte für die Randfaserdehnung errechnet. (Bodo Carlowitz: Tabellarische Übersicht über die Prüfung von Kunststoffen, 6. Auflage, Giesel-Verlag für Publizität, 1992, S. 16-17)

**Bevorzugte Ausführungsformen der Erfindung**

In einer bevorzugten Ausführungsform enthalten die erfindungsgemäßen Zusammensetzungen zusätzlich zu den Komponenten a) und b) und gegebenenfalls c) noch

d) 0,01 bis 5 Gew.-%, bevorzugt 0,05 bis 4 Gew.-%, besonders bevorzugt 0,1 bis 3 Gew.-% wenigstens eines Phosphitstabilisators, wobei die Menge wenigstens einer der Komponenten a), b) und gegebenenfalls, c) in der Weise zu reduzieren ist, dass die Summe aller Gewichtsprozente 100 ergibt.

In einer bevorzugten Ausführungsform enthalten die erfindungsgemäßen Zusammensetzungen zusätzlich zu den Komponenten a), b) sowie gegebenenfalls c) und/oder d) oder anstelle von c) und/oder d) noch

e) 0,01 bis 10 Gew.% wenigstens eines Additives zur Verbesserung der Fließfähigkeit, auch als Fließhilfsmittel,

Fließmittel, Fließhilfe oder inneres Gleitmittel bezeichnet, wobei die Menge wenigstens einer der übrigen Komponenten soweit zu reduzieren ist, dass die Summe aller Gewichtsprozente 100 ergibt.

In einer bevorzugten Ausführungsform enthalten die erfindungsgemäßen Zusammensetzungen zusätzlich zu den Komponenten a), b) sowie gegebenenfalls c) und/oder d) und/oder e) oder anstelle von c) und/oder d) und/oder e) noch

f) 0,01 bis 5 Gew.-%, bevorzugt 0,1 bis 2 Gew.-%, besonders bevorzugt 0,5 bis 1 Gew.-% wenigstens einer Form von Ruß, wobei die Menge wenigstens einer der übrigen Komponenten soweit zu reduzieren ist, dass die Summe aller Gewichtsprozente 100 ergibt.

In einer bevorzugten Ausführungsform enthalten die erfindungsgemäßen Zusammensetzungen zusätzlich zu den Komponenten a), b) sowie gegebenenfalls c) und/oder d) und/oder e) und/oder f) oder anstelle der Komponenten c) und/oder d) und/oder e) und/oder f) noch

g) 0,01 bis 15 Gew.-%, bevorzugt 0,01 bis 10 Gew.-%, besonders bevorzugt 0,01 bis 5 Gew.-% wenigstens eines Entformungsmittels, wobei die Menge wenigstens einer der übrigen Komponenten soweit zu reduzieren ist, dass die Summe aller Gewichtsprozente 100 ergibt.

In einer bevorzugten Ausführungsform enthalten die erfindungsgemäßen Zusammensetzungen zusätzlich zu den Komponenten a), b) sowie gegebenenfalls c) und/oder d) und/oder e) und/oder f) und/oder g) oder anstelle der Komponenten c) sowie gegebenenfalls d) und/oder e) und/oder f) und/oder g) noch

h) 0,01 bis 45 Gew.-%, bevorzugt 0,01 bis 30 Gew.-%, besonders bevorzugt 0,01 bis 15 Gew.-% wenigstens eines sonstigen, zu den Komponenten c) und/oder d) und/oder e) und/oder f) und/oder g) unterschiedlichen Additivs, wobei die Mengen wenigstens einer der übrigen Komponenten soweit zu reduzieren ist, dass die Summe aller Gewichtsprozente 100 ergibt.

**Komponente a)**

Erfindungsgemäß wird als Komponente a) wenigstens ein Polyester eingesetzt, bevorzugt wenigstens ein Polyalkylenterephthalat oder Polycycloalkylenterephthalat, besonders bevorzugt wenigstens ein Polyester der Gruppe Polybutylenterephthalat (PBT), Polyethylenterephthalat (PET), Poly(1,4-cyclohexandimethanolterephthalat) (PCT), oder ein Blend auf Basis von PBT und PET, oder ein Blend auf Basis von PBT und PCT, oder ein Blend auf Basis von PET und PCT oder ein Blend auf Basis von PBT, PET und PCT. Ganz besonders bevorzugte Blends sind aus PBT und PET worin der Anteil an PET bezogen auf die Summe aller enthaltenen Polyester im Bereich von 50 bis 99,9 Gew-% liegt.

Die erfindungsgemäß einzusetzenden Polyester sind Reaktionsprodukte aus aromatischen Dicarbonsäuren oder ihren reaktionsfähigen Derivaten, bevorzugt Dimethylestern oder Anhydriden, und aliphatischen, cycloaliphatischen oder araliphatischen Diolen und Mischungen dieser Edukte. Sie lassen sich aus Terephthalsäure (oder ihren reaktionsfähigen Derivaten) und den jeweiligen aliphatischen Diolen mit 2 bzw. 4 C-Atomen bzw. dem cycloaliphatischen 1,4-Bis(hydroxymethyl)-cyclohexan nach bekannten Methoden herstellen (Kunststoff-Handbuch, Bd. VIII, S. 695 FF, Karl-Hanser-Verlag, München 1973).

Bevorzugt als Polyester einzusetzendes PET enthält mindestens 80 Mol-%, vorzugsweise mindestens 90 Mol-%, bezogen auf die Dicarbonsäure, Terephthalsäurereste und mindestens 80 Mol-%, vorzugsweise mindestens 90 Mol-%, bezogen auf die Diolkomponente, Ethylenglykolreste.

Bevorzugt als Polyester einzusetzendes PBT enthält mindestens 80 Mol-%, vorzugsweise mindestens 90 Mol-%, bezogen auf die Dicarbonsäure, Terephthalsäurereste und mindestens 80 Mol-%, vorzugsweise mindestens 90 Mol-%, bezogen auf die Diolkomponente, Butandiol-1,4-glykol Reste.

Bevorzugt als Polyester einzusetzendes PCT enthält mindestens 80 Mol-%, vorzugsweise mindestens 90 Mol-%, bezogen auf die Dicarbonsäure, Terephthalsäurereste und mindestens 80 Mol-%, vorzugsweise mindestens 90 Mol-%, bezogen auf die Diolkomponente, 1,4-Bis(hydroxymethyl)-cyclohexanglykol Reste.

Die bevorzugt einzusetzenden und oben genannten Polyester können neben Terephthalsäureresten bis zu 20 Mol-% Reste anderer aromatischer Dicarbonsäuren mit 8 bis 14 C-Atomen oder Reste aliphatischer Dicarbonsäuren mit 4 bis 12 C-Atomen enthalten, bevorzugt Reste von Phthalsäure, Isophthalsäure, Naphthalin-2,6-dicarbonsäure, 4,4'-Diphenyldicarbonsäure, Bernsteinsäure, Adipinsäure, Sebacinsäure, Azelainsäure, Cyclohexandiessigsäure, oder Cyclohexandicarbonsäure.

Die bevorzugt einzusetzenden und oben genannten Polyester können neben Ethylenglykolresten, Butandiol-1,4-glykolresten bzw. 1,4-Bis(hydroxymethyl)-cyclohexanglykolresten bis zu 20 Mol-% andere Reste aliphatischer Diole

mit 3 bis 12 C-Atomen oder cycloaliphatischer Diole mit 6 bis 21 C-Atomen enthalten. Bevorzugt sind Reste von Propandiol-1,3, 2-Ethylpropandiol-1,3, Neopentylglykol, Pentan-diol-1,5, Hexandiol-1.6, 3-Methylpentandiol-2,4, 2-Methylpentandiol-2,4, 2,2,4-Trimethylpentandiol-1,3, 2,2,4-Trimethyl¬pentandiol-1,6, 2-Ethylhexandiol-1,3, 2,2-Diethylpropandiol-1,3, Hexandiol-2,5, 1,4-Di-(ß-hydroxyethoxy)-benzol, 2,2-Bis-(4-hydroxycyclohexyl)-propan, 2,4-Dihydroxy-1,1,3,3-tetra-methyl-cyclobutan, 2,2-Bis-(3-ß-hydroxyethoxyphenyl)-propan oder 2,2-Bis-(4-hydroxy-propoxyphenyl)-propan (DE-A 24 07 674 (= US 4 035 958), DE-A 24 07 776, DE-A 27 15 932 (=US 4 176 224)).

In einer Ausführungsform können die bevorzugt einzusetzenden und oben genannten Polyester durch Einbau relativ kleiner Mengen 3- oder 4-wertiger Alkohole oder 3- oder 4-basischer Carbonsäuren, wie sie z.B. in der DE-A 19 00 270 (= US-A 3 692 744) beschrieben sind, verzweigt werden. Bevorzugte Verzweigungsmittel sind Trimesinsäure, Trimellitsäure, Trimethylolethan und Trimethylolpropan und Pentaerythrit.

Die erfindungsgemäß bevorzugt einzusetzenden und oben genannten Polyester besitzen bevorzugt eine intrinsische Viskosität im Bereich von ca. 30 $cm^3/g$ bis 150 $cm^3/g$, besonders bevorzugt im Bereich von 40 $cm^3/g$ bis 130 $cm^3/g$, insbesondere bevorzugt im Bereich von 50 $cm^3/g$ bis 100 $cm^3/g$ jeweils gemessen in Phenol/o-Dichlorbenzol (1:1 Gew.-Teile) bei 25°C mittels eines Ubbelohde Viskosimeters. Die intrinsische Viskosität [η] wird auch Grenzviskositätszahl oder Staudinger Index genannt, da sie erstens eine Stoffkonstante ist und zweitens in einem Zusammenhang mit dem Molekulargewicht steht. Sie gibt an, wie die Viskosität des Lösungsmittels durch den gelösten Stoff beeinflusst wird. Zur Bestimmung der intrinsischen Viskosität wird die folgende Definition verwendet:

$$[\eta] = \lim_{c \to 0} \frac{\eta_{sp}}{c} = \lim_{c \to 0} \frac{1}{c} \ln\left(\frac{\eta}{\eta_0}\right)$$

wobei c die Konzentration des gelösten Stoffs in g/ml, $\eta_0$ die Viskosität des reinen Lösungsmittels und

$\eta_{sp} = \frac{\eta}{\eta_0} - 1$ die spezifische Viskosität ist.

Zur Messung der Viskosität wird das zu untersuchende Material auf einen Feuchtegehalt von maximal 0.02%, ermittelt mittels der dem Fachmann bekannten Karl Fischer Methode, in einem handelsüblichen Umlufttrockner bei 120°C getrocknet (siehe: http://de.wikipedia.org/wiki/Karl-Fischer-Verfahren).

Erfindungsgemäß einzusetzendes PBT (CAS No. 24968-12-5) kann beispielsweise von der Lanxess Deutschland GmbH, Köln, Deutschland, unter der Bezeichnung Pocan® B1300 erworben werden.

Erfindungsgemäß einzusetzendes PET (CAS No. 25038-59-9) kann beispielsweise in Form von Polyester Chips PET V004 von der Firma Invista, Wichita, USA bezogen werden.

Erfindungsgemäß einzusetzendes PCT (CAS No. 24936-69-4) kann beispielsweise von SK Chemicals unter dem Handelsnamen Puratan® bezogen werden. Die als Komponente a) einzusetzenden Polyester können gegebenenfalls auch im Gemisch mit anderen Polyestern und/oder weiteren Polymeren eingesetzt werden.

**Komponente b)**

Als Komponente b) wird triklin-pinakoidales Aluminiumsilikat ($Al_2SiO_5$) eingesetzt, bekannt auch unter der Bezeichnung Kyanit (CAS No. 1302-36-7). Kyanit bezeichnet ein Aluminiumsilikat mit spezieller Kristallform, triklin-pinakoidal, und wird auch unter den Namen Cyanit, Disthen oder Sapparit geführt. Die seit 2001 gültige und von der International Mineralogical Association (IMA) verwendete 9. Auflage der Strunz'schen Mineralsystematik ordnet Kyanit in die Klasse "Silikate und Germanate" und dort in die Abteilung der "Inselsilikate (Nesosilikate)"ein. Diese Abteilung ist allerdings weiter unterteilt nach der möglichen Anwesenheit weiterer Anionen sowie der Koordination der beteiligten Kationen, so dass das Mineral entsprechend seiner Zusammensetzung in der Unterabteilung der "Inselsilikate mit zusätzlichem Anionen; Kationen in [4]er, [5]er und/oder nur [6]er-Koordination" zu finden ist, wo es einziges Mitglied der unbenannten Gruppe 9.AF.15 ist. Bevorzugt wird das triklin-pinakoidale $Al_2SiO_5$ als Pulver eingesetzt. Bevorzugte Pulver weisen eine mittlere Partikelgröße $d_{50}$ von maximal 500 μm, bevorzugt 0,1 bis 250 μm, besonders bevorzugt 0,5 bis 150 μm, ganz besonders bevorzugt 0,5 bis 70 μm auf - Bestimmung der mittleren Partikelgröße erfolgt in Analogie zu ASTM D 1921-89, Methode A - , wodurch die feine Verteilung im Thermoplasten bzw. in den erfindungsgemäßen Mischungen und thermoplastischen Formmassen gewährleistet wird.

Die erfindungsgemäß zu verwendenden triklin-pinakoidalen $Al_2SiO_5$-Partikel, können in unterschiedlichen Formen vorliegen, die durch das Aspektverhältnis beschrieben werden können. Bevorzugt werden Partikel mit einem Aspektverhältnis von 1 bis 100, besonders bevorzugt 1 bis 30, ganz besonders bevorzugt 1 bis 10 eingesetzt, wobei dieses

beispielsweise durch ein Verfahren gemäß EP 0 528 078 A1 bestimmt werden kann.

Die erfindungsgemäß zu verwendenden $Al_2SiO_5$-Partikel mit triklin-pinakoidaler Kristallstruktur, können mit und ohne Oberflächenmodifizierung eingesetzt werden. Als Oberflächenmodifizierung werden organische Kopplungsmittel bezeichnet, welche die Anbindung an die thermoplastische Matrix verbessern sollen. Als Oberflächenmodifizierung werden bevorzugt Aminosilane, Epoxysilane, Methacrylsilane, Trimethylsilane, Methylsilane oder Vinylsilane, besonders bevorzugt Epoxysilane oder Methacrylsilane eingesetzt. In einer bevorzugten Ausführungsform werden die erfindungsgemäß zu verwendenden triklin pinakoidalen $Al_2SiO_5$-Partikel, bzw. Kyanit-Partikel, ohne Oberflächenmodifizierung eingesetzt. Anbieter von Kyanit ist beispielsweise Quarzwerke GmbH, Frechen, Deutschland, die das Kyanit als $Al_2SiO_5$ unter Silatherm® vertreiben.

**Komponente c)**

Als Komponente c) wird Talkum eingesetzt, bevorzugt mikrokristallines Talkum. Talkum (CAS No. 14807-96-6), auch als Talk bezeichnet, ist ein Schichtsilikat mit der chemischen Zusammensetzung $Mg_3[Si_4O_{10}(OH)_2]$, das je nach Modifikation als Talk-1A im triklinen oder als Talk-2M im monoklinen Kristallsystem kristallisiert (http://de.wikipedia.org/wiki/Talkum).

Mikrokristalliner Talk im Sinne der vorliegenden Erfindung wird in WO 2014/001158 A1 beschrieben, deren Inhalt von der vorliegenden Offenbarung vollumfänglich umfasst wird. In einer Ausführungsform der vorliegenden Erfindung wird mikrokristalliner Talk mit einer mittleren Teilchengröße d50 bestimmt nach SediGraph im Bereich von 0,5 bis 10 μm eingesetzt, bevorzugt im Bereich von 1,0 bis 7,5 μm, besonders bevorzugt im Bereich von 1,5 bis 5,0 μm und ganz besonders bevorzugt im Bereich von 1,8 bis 4,5 μm.

Wie in WO 2014/001158 A1 beschrieben, erfolgt im Rahmen der vorliegenden Erfindung die Teilchengrößenbestimmung des erfindungsgemäß einzusetzenden Talks durch Sedimentation in einem vollständig dispergierten Zustand in einem wässrigen Medium mit Hilfe eines "Sedigraph 5100", wie er von Micrometrics Instruments Corporation, Norcross, Georgia, USA, geliefert wird. Der Sedigraph 5100 liefert Messungen und einen Plot vom kumulativen Gewichtsprozentsatz von Teilchen mit einer Größe, die in der Technik als "Äquivalenter Kugeldurchmesser" (esd) bezeichnet wird, abzüglich der gegebenen esd-Werte. Die mittlere Teilchengröße d50 ist der aus der Teilchen-esd ermittelte Wert, zu dem 50 Gew.-% der Teilchen einen äquivalenten Kugeldurchmesser kleiner als diesen d50 Wert aufweisen. Die zugrunde liegende Norm ist ISO 13317-3.

In einer Ausführungsform ist mikrokristalliner Talk über die BET Oberfläche definiert. Erfindungsgemäß einzusetzender mikrokristalliner Talk weist bevorzugt eine BET Oberfläche, zu bestimmen in Analogie zu DIN ISO 9277, im Bereich von 5 bis 25 $m^2 \cdot g^{-1}$ auf, besonders bevorzugt im Bereich von 10 bis 18 $m^2 \cdot g^{-1}$, ganz besonders bevorzugt im Bereich von 12 bis 15 $m^2 \cdot g^{-1}$.

Erfindungsgemäß einzusetzendes Talkum kann beispielsweise als Mistron® R10 von Imerys Talc Group, Toulouse, Frankreich (Rio Tinto Group) bezogen werden.

**Komponente d)**

Als Komponente d) wird bevorzugt wenigstens ein Phosphitstabilisator aus der Gruppe Tris(2,4-ditert-butylphenyl)phosphit (Irgafos® 168, BASF SE, CAS No.31570-04-4), Bis(2,4-di-tert-butylphenyl)pentaerythritol-diphosphit (Ultranox® 626, Chemtura, CAS No.26741-53-7), Bis(2,6-di-tert-butyl-4-methylphenyl)pentaerythritol-diphosphit (ADK Stab PEP-36, Adeka, CAS No.80693-00-1), Bis(2,4-dicumylphenyl)pentaerythritol-diphosphit (Doverphos® S-9228, Dover Chemical Corporation, CAS No.154862-43-8), Tris(nonylphenyl)phosphit (Irgafos® TNPP, BASF SE, CAS No.26523-78-4), (2,4,6-tri-t-butylphenol)2-butyl-2-ethyl-1,3-propanediol-phosphit (Ultranox® 641, Chemtura, CAS No.161717-32-4) und Tetrakis(2,4-di-tert-butylphenyl)-1,1-biphenyl-4,4'-diylbisphosphonit (Hauptbestandteil des Hostanox® P-EPQ) ausgewählt und eingesetzt.

Insbesondere bevorzugt wird als Phosphitstabilisator wenigstens Hostanox® P-EPQ (CAS No. 119345-01-6) der Clariant International Ltd., Muttenz, Schweiz eingesetzt. Dieses enthält das erfindungsgemäß insbesondere ganz besonders bevorzugt als Komponente d) einzusetzende Tetrakis(2,4-di-tert-butylphenyl)-1,1-biphenyl-4,4'-diylbisphosphonit (CAS No. 38613-77-3).

**Komponente e)**

Das erfindungsgemäß als Komponente e) einzusetzende Additiv zur Verbesserung der Fließfähigkeit wird auch als Fließhilfsmittel, Fließmittel, Fließhilfe oder inneres Gleitmittel bezeichent. Derartige Fließhilfsmittel sind aus der Literatur wie z.B. in Kunststoffe 2000, 90 (9), S. 116-118 bekannt und können bevorzugt Fettsäureester von Polyolen oder Amide aus Fettsäuren und Aminen sein. Alternativ zu den oberflächenaktiven Fließhilfsmitteln können interne Fließhilfsmittel eingesetzt werden, die mit den Polymerharzen verträglich sind. Hierfür eignen sich bevorzugt niedermolekulare Verbindungen oder verzweigte, hochverzweigte oder dendritische Polymere mit einer dem Polymerharz ähnlichen Polarität. Derartige hochverzweigte oder dendritische Systeme sind literaturbekannt und können bevorzugt auf verzweigten Polyestern, Polyamiden, Polyesteramiden, Polyethern oder Polyaminen basieren, wie sie in Kunststoffe 2001, 91 (10), S. 179-190, oder in Advances in Polymer Science 1999, 143 (Branched Polymers II), S. 1-34 beschrieben sind. Besonders bevorzugt werden Copolymerisate von α-Olefinen mit Methacrylsäureestern oder Acrylsäureestern aliphatischer Alkohole verwendet. Sie können beispielsweise von Atofina Deutschland, Düsseldorf unter dem Handelsnamen Lotryl® bezogen werden.

Bevorzugt als Komponente e) einzusetzende Fließhilfsmittel sind Copolymerisate aus mindestens einem α-Olefin mit mindestens einem Methacrylsäureester oder Acrylsäureester eines aliphatischen Alkohols, vorzugsweise eines aliphatischen Alkohols mit 1-30 Kohlenstoffatomen, wobei der MFI (Melt Flow Index) des Copolymerisats 100 g/10 min, vorzugsweise 150 g/10 min, nicht unterschreitet und der MFI (Melt Flow Index) wurde im Rahmen der vorliegenden Erfindung in Analogie zur ISO 1133 einheitlich bei 190°C und einem Prüfgewicht von 2,16 kg gemessen bzw. bestimmt wird. In einer bevorzugten Ausführungsform enthält das Copolymerisat keine weiteren reaktiven funktionellen Gruppen.

Der Schmelzfliessindex (engl. MFI = Melt Flow Index oder MFR = Melt Flow Rate) dient zur Charakterisierung des Fließverhaltens (Formmassenprüfung) eines thermoplastischen Werkstoffes bei bestimmten Druck- und Temperaturbedingungen. Er ist ein Maß für die Viskosität der Kunststoffschmelze. Daraus lässt sich auf den Polymerisationsgrad, also die mittlere Anzahl von Monomereinheiten in einem Molekül schließen. Der MFI gibt die Masse von Polymerschmelze an, die unter Normbedingungen in einer bestimmten Zeit mit einem Zylinder durch eine Düse gedrückt wird. Die Einheit für den MFI ist g/10min. Wird ein Kunststoff - beispielsweise durch Chemikalienangriff oder Strahlung - so geschädigt, dass ein Kettenabbau einsetzt, so verringert sich seine Schmelzviskosität und die Schmelzvolumenrate steigt. Zur Messung des MFI wird ein senkrecht stehender Metallzylinder auf konstante Temperatur beheizt. Der Zylinder endet am unteren Ende der Normdüse. Die zu prüfende Polymermasse (ca. 5 g) wird in den Zylinder gegeben. Ein Kolben mit dem aufgesetzten materialabhängigen Gewicht, im vorliegenden Fall von 2,16 kg, drückt die Masse durch die Düse (siehe auch http://www.schmelzindex.de/). Bei der MFI Messung unterscheidet man folgende Schritte:

1. Prüftemperatur und Prüfgewicht wählen (ISO 1133)

2. Die Schmelze wird in den durchgeheizten Zylinder gegeben und manuell verdichtet

3. Vorheizzeit ohne Belastung 240s und Gesamtvorheizzeit 300s

4. Das erste austretende Strangstück wird verworfen

5. Ist die Schmelze blasenfrei, werden in konstanten Zeitabständen z.B. alle 60s, abhängig vom Materialfluss, Strangabschnitte abgetrennt und nach Abkühlung gewogen und auf 10 min hochgerechnet

6. Materialmenge je nach Schmelzefluss, max. 30mm (Kolben unterer und oberer Ring)

7. Der Schmelzindex gibt an, wie viel Gramm eines Kunststoffs in 10 min durch eine Kapillare bestimmter Geometrie gepresst wird; die Einheit ist also g/10min.

Es gilt folgender Zusammenhang: MFI = 600 • m/t worin m für das mittlere Gewicht der Strangabschnitte und t für den Zeitabstand in Sekunden steht.

Erfindungsgemäß bevorzugt geeignete α-Olefine als Bestandteil der als Fließhilfsmittel e) einzusetzenden Copolymerisate weisen zwischen 2 und 10 Kohlenstoff-Atomen auf und können unsubstituiert oder mit einer oder mehreren aliphatischen, cycloaliphatischen oder aromatischen Gruppen substituiert sein. Bevorzugte α-Olefine sind ausgewählt aus der Gruppe umfassend Ethen, Propen, 1-Buten, 1-Penten, 1-Hexen, 1-Octen, 3-Methyl-1-penten. Besonders bevorzugte α-Olefine sind Ethen und Propen, ganz besonders bevorzugt ist Ethen. Ebenfalls geeignet sind Mischungen der beschriebenen α-Olefine.

Der Gehalt des α-Olefins im als Fließhilfsmittel e) einzusetzenden Copolymerisat liegt im Bereich von 50 bis 90 Gew.-%, bevorzugt im Bereich von 55 bis 75 Gew.-% des gesamten Copolymersats.

Das als Komponente e) und Fließhilfsmittel einzusetzende Copolymerisat wird weiterhin definiert durch den zweiten Bestandteil neben dem α-Olefin. Als zweiter Bestandteil sind Alkyl- oder Arylalkylester der Acrylsäure oder Methacrylsäure geeignet, deren Alkyl- oder Arylalkylgruppe aus 1-30 Kohlenstoffatomen gebildet wird und keine oder nur eine geringe Konzentration an reaktiven Funktionen ausgewählt aus der Gruppe umfassend Epoxide, Oxetane, Anhydride, Imide, Aziridine, Furane, Säuren, Amine enthält. Die Alkyl- oder Arylalkylgruppe kann dabei linear oder verzweigt sein sowie cycloaliphatische oder aromatische Gruppen enthalten, daneben auch durch eine oder mehrere Ether- oder Thioetherfunktionen substituiert sein. Bevorzugt geeignete Methacrylsäureester oder Acrylsäureester in

diesem Zusammenhang sind auch solche, die aus einer Alkoholkomponente synthetisiert wurden, die auf Oligoethylenglycol oder Oligopropylenglycol mit nur einer Hydroxylgruppe und maximal 30 C-Atomen basieren.

Besonders bevorzugt wird die Alkyl- oder Arylalkylgruppe des Methacrylsäure- oder Acrylsäureesters ausgewählt aus der Gruppe umfassend 1-Pentyl, 1-Hexyl, 2-Hexyl, 3-Hexyl, 1-Heptyl, 3-Heptyl, 1-Octyl, 1-(2-Ethyl)-hexyl, 1-Nonyl, 1-Decyl, 1-Dodecyl, 1-Lauryl oder 1-Octadecyl. Ganz besonders bevorzugt sind Alkyl- oder Arylalkylgruppen mit 6-20 Kohlenstoffatomen. Bevorzugt sind insbesondere auch verzweigte Alkylgruppen, die im Vergleich zu linearen Alkylgruppen gleicher Anzahl an Kohlenstoffatomen zu einer niedrigeren Glasübergangs-Temperatur $T_G$ führen.

Erfindungsgemäß insbesondere bevorzugt als Komponente e) einzusetzende Copolymerisate sind solche, bei denen das $\alpha$-Olefin mit Acrylsäure-(2-ethyl)-hexylester copolymerisiert wird.

Ebenfalls geeignet sind Mischungen der beschriebenen Acrylsäure- oder Methacrylsäurester.

Der Gehalt der Acrylsäure- oder Methacrylsäureester im als Komponente e) einzusetzenden Copolymerisat liegt bevorzugt im Bereich von 10 bis 50 Gew.-%, besonders bevorzugt im Bereich von 25 bis 45 Gew.-% des gesamten Copolymerisats.

Als Komponente e) bevorzugt einzusetzende Copolymerisate zeichnen sich neben der Zusammensetzung durch das niedrige Molekulargewicht aus. Dementsprechend sind für die Komponente e) insbesondere Copolymerisate geeignet, die einen MFI-Wert gemessen bei 190°C und einer Belastung von 2,16 kg von mindestens 100 g/10 min, bevorzugt von mindestens 150 g/10 min aufweisen. Erfindungsgemäß insbesondere bevorzugt einzusetzende Copolymerisate werden beispielsweise als Lotryl® 37 EH 175 oder Lotryl® 37 EH 550 von der Arkema, Puteaux, Frankreich, angeboten.

**Komponente f)**

Erfindungsgemäß wird als Komponente f) wenigstens eine Form von Ruß (CAS No. 1333-86-4) eingesetzt. Zur Unterscheidung wird für den gezielt hergestellten Industrie-Grundstoff meist der englische Begriff Carbon Black gebraucht, manchmal auch noch der ältere Begriff Industrieruß. Industrieruß ist eine Modifikation des Kohlenstoff mit sehr hoher Oberfläche und wird vor allem als Füllstoff und als Schwarzpigment verwendet. International üblich ist die Klassifizierung von Standardrußen nach der US-amerikanischen ASTM-Norm. Bevorzugt wird Ruß mit einer Partikelgröße im Bereich von 5 bis 60 nm, besonders bevorzugt im Bereich von 10 und 40 nm und ganz besonders bevorzugt im Bereich von 15 und 25 nm eingesetzt. Die erfindungsgemäß einzusetzenden Ruße werden bevorzugt als Pulver oder Perlen eingesetzt. Ganz Besonders bevorzugt als Komponente f) einzusetzende Ruße werden ausgewählt aus der Gruppe der ASTM-Normen N220, N234, N294, N330, N326, N347, N440, N472, N539, N550, N568, N601, N660, N762, N770, N785, N880 und N990 (http://de.wikipedia.org/wiki/Ru%C3%9F).Erfindungsgemäß als Komponente f) einzusetzender Ruß wird auch als Schwarz-Pigment (C. I. Pigment Black 7) bezeichnet. Weitere Typen beinhalten Orion Cabot black Pigments (PRINTEX, HIBLACK, AROSPERSE, NIPex, NEROX, COLOUR BLACK, SPECIAL BLACK), oder vom Hersteller Birla Carbon die Typen Raven, Conductex, Copeblack oder vom Hersteller Cabot die Typen BLACK PEARLS, ELFTEX, MOGUL, MONARCH, REGAL, SPHERON, STERLING, VULCAN, CSX, CRX, IRX, UNITED. Als Füllstoff einzusetzende Ruße besitzen bevorzugt BET-Oberflächen im Bereich von 5 bis 200 $m^2/g$, bestimmt in Analogie zu DIN ISO 9277:2003-05.

**Komponente g)**

Erfindungsgemäß wird als Komponente g) wenigstens ein Entformungsmittel eingesetzt. Als bevorzugte Entformungsmittel wird wenigstens eines ausgewählt aus der Reihe Esterwachs(e), Pentaerytritoltetrastearat (PETS), langkettige Fettsäuren, Salz(e) der langkettigen Fettsäuren, Amidderivat(e) der langkettigen Fettsäuren, Montanwachse sowie niedermolekulare Polyethylen- bzw. Polypropylenwachs(e) oder Ethylen Homopolymer Wachs(e).

Bevorzugte langkettige Fettsäuren sind Stearinsäure oder Behensäure. Bevorzugte Salze langkettiger Fettsäuren sind Calciumstearat oder Zinkstearat. Bevorzugtes Amidderivat langkettiger Fettsäuren ist Ethylen-bis-stearylamid (CAS No. 110-30-5). Bevorzugte Montanwachse sind Mischungen aus geradkettigen, gesättigten Carbonsäuren mit Kettenlängen von 28 bis 32 C-Atomen.

**Komponente h)**

Erfindungsgemäß wird als Komponente h) wenigstens ein Additiv eingesetzt, das sich von den Komponenten b), c), d), e), f) und g) unterscheidet.

Bevorzugte Additive der Komponente h) sind Stabilisatoren, UV-Stabilisatoren, Gammastrahlenstabilisatoren, Antistatika, Fließhilfsmittel, Flammschutzmittel, Elastomermodifikatoren, Brandschutzadditive, Emulgatoren, Nukleierungsmittel, Säurefänger, Weichmacher, Gleitmittel, Farbstoffe oder Pigmente sowie gegebenenfalls zusätzliche von der Komponente b) unterschiedliche Wärmeleitfähigkeitsadditive. Die genannten und weitere geeignete Additive

sind zum Beispiel beschrieben in Gächter, Müller, Kunststoff-Additive, 3. Ausgabe, Hanser-Verlag, München, Wien, 1989 und im Plastics Additives Handbook, 5th Edition, Hanser-Verlag, München, 2001. Die Additive können alleine oder in Mischung bzw. in Form von Masterbatchen eingesetzt werden.

Als von Komponente d) unabhängig einzusetzende Stabilisatoren werden bevorzugt sterisch gehinderte Phenole, Hydrochinone, aromatische sekundäre Amine wie Diphenylamine, substituierte Resorcine, Salicylate, Benzotriazole und Benzophenone, sowie verschieden substituierte Vertreter dieser Gruppen oder deren Mischungen eingesetzt.

Als von Komponente f) unabhängig einzusetzende Pigmente bzw. Farbstoffe werden bevorzugt Zinksulfid, Titandioxid, Ultramarinblau, Eisenoxid, Phthalocyanine, Chinacridone, Perylene, Nigrosin und Anthrachinone eingesetzt. Das als Pigment bevorzugt einzusetzende Titandioxid (CAS No. 13463-67-7) hat bevorzugt eine mittlere Teilchengröße im Bereich von 90 nm bis 2000 nm. Wie in WO 2014/001158 A1 beschrieben, erfolgt auch im Rahmen der vorliegenden Erfindung die Teilchengrößenbestimmung durch Sedimentation in einem vollständig dispergierten Zustand in einem wässrigen Medium mit Hilfe eines "Sedigraph 5100" wie er von Micrometrics Instruments Corporation, Norcross, Georgia, USA, geliefert wird. Der Sedigraph 5100 liefert Messungen und einen Plot vom kumulativen Gewichtsprozentsatz von Teilchen mit einer Größe, die in der Technik als "Äquivalenter Kugeldurchmesser" (esd) bezeichnet wird, abzüglich der gegebenen esd-Werte. Die mittlere Teilchengröße d50 ist der aus der Teilchen-esd ermittelte Wert, zu dem 50 Gew.-% der Teilchen einen äquivalenten Kugeldurchmesser kleiner als diesen d50 Wert aufweisen. Die zugrunde liegende Norm ist ISO 13317-3.

Für das erfindungsgemäß als Pigment bevorzugt einzusetzende Titandioxid kommen Titandioxid-Pigmente in Frage, deren Grundkörper nach dem Sulfat (SP)- oder Chlorid (CP)-Verfahren hergestellt sein können und die Anatas (CAS No. 1317-70-0) und / oder Rutilstruktur (CAS No. 1317-80-2), bevorzugt Rutilstruktur haben. Der Grundkörper muss nicht stabilisiert sein, jedoch ist eine spezielle Stabilisierung bevorzugt: beim CP-Grundkörper durch eine Al-Dotierung von 0,3-3,0 Gew.-% (gerechnet als $Al_2O_3$) und einen Sauerstoffüberschuss in der Gasphase bei der Oxidation des Titantetrachlorids zu Titandioxid von mindestens 2 %; beim SP-Grundkörper durch eine Dotierung z. B. mit Al, Sb, Nb oder Zn. Besonders bevorzugt, um eine hinreichend hohe Helligkeit der aus den erfindungsgemäßen Zusammensetzungen herzustellenden Erzeugnisse zu erhalten, ist eine "leichte" Stabilisierung mit Al bevorzugt, bzw. bei höheren Al-Dotierungsmengen eine Kompensation mit Antimon. Bei der Verwendung von Titandioxid als Weißpigment in Farben und Lacken, Kunststoffen usw. ist bekannt, dass durch UV-Absorption erzeugte unerwünschte photokatalytische Reaktionen zur Zersetzung des pigmentierten Materials führen. Dabei absorbieren Titandioxid-Pigmente im nahen ultravioletten Bereich Licht, so dass Elektron-Loch-Paare entstehen, welche hochreaktive Radikale auf der Titandioxid-Oberfläche erzeugen. Die gebildeten Radikale haben in organischen Medien einen Bindemittelabbau zur Folge. Erfindungsgemäß bevorzugt wird zur Erniedrigung der Photoaktivität des Titandioxids dieses anorganisch nachbehandelt, besonders bevorzugt mit Oxiden von Si und / oder Al und / oder Zr und / oder durch den Einsatz von Sn-Verbindungen.

Bevorzugt ist die Oberfläche von pigmentärem Titandioxid mit amorphen Ausfällungen von Oxidhydraten der Verbindungen $SiO_2$ und / oder $Al_2O_3$ und / oder Zirkonoxid bedeckt. Die $Al_2O_3$-Hülle erleichtert die Pigmentdispergierung in der Polymermartrix, die $SiO_2$-Hülle erschwert den Ladungsaustausch an der Pigmentoberfläche und verhindert dadurch den Polymerabbau.

Erfindungsgemäß wird das Titandioxid bevorzugt mit hydrophilen und/oder hydrophoben organischen Beschichtungen versehen, insbesondere mit Siloxanen oder Polyalkoholen. Kommerziell erhältliche Titandioxid Produkte sind beispielsweise Kronos® 2230, Kronos® 2225 und Kronos® vlp7000 der Fa. Kronos, Dallas, USA.

Als Nukleierungsmittel, zusätzlich dem unter c) beschriebenen Talkum, werden bevorzugt Natrium- oder Calciumphenylphosphinat, Aluminiumoxid oder Siliziumdioxid eingesetzt

Als Säurefänger werden bevorzugt Hydrotalcit, Kreide, Böhmit oder Zinkstannate eingesetzt.

Als Weichmacher werden bevorzugt Phthalsäuredioctylester, Phthalsäuredibenzylester, Phthalsäurebutylbenzylester, Kohlenwasserstofföle oder N-(n-Butyl)benzolsulfonamid eingesetzt.

Als Elastomermodifikator einzusetzendes Additiv wird bevorzugt eines oder mehrere Pfropfpolymerisat(e) E von

E.1 5 bis 95 Gew.-%, vorzugsweise 30 bis 90 Gew.-%, wenigstens eines Vinylmonomeren auf

E.2 95 bis 5 Gew.-%, vorzugsweise 70 bis 10 Gew.-% einer oder mehrerer Pfropfgrundlagen mit Glasübergangstemperaturen < 10°C, vorzugsweise < 0°C, besonders bevorzugt <-20°C eingesetzt.

Die Pfropfgrundlage E.2 hat im Allgemeinen eine mittlere Teilchengröße ($d_{50}$-Wert) von 0,05 bis 10 $\mu$m, vorzugsweise 0,1 bis 5 $\mu$m, besonders bevorzugt 0,2 bis 1 $\mu$m.

Monomere E.1 sind vorzugsweise Gemische aus

E.1.1 50 bis 99 Gew.-% Vinylaromaten und/oder kernsubstituierten Vinylaromaten (wie beispielsweise Styrol, $\alpha$-Methylstyrol, p-Methylstyrol, p-Chlorstyrol) und/oder Methacryl-säure-($C_1$-$C_8$)-Alkylester (wie z.B. Methylmethacrylat, Ethylmethacrylat) und

E.1.2 1 bis 50 Gew.-% Vinylcyanide (ungesättigte Nitrile wie Acrylnitril und Methacrylnitril) und/oder (Meth)Acrylsäure-($C_1$-$C_8$)-Alkylester (wie z.B. Methylmethacrylat, n-Butylacrylat, t-Butylacrylat) und/oder Derivate (wie Anhydride und Imide) ungesättigter Carbonsäuren (beispielsweise Maleinsäureanhydrid und N-Phenyl-Maleinimid).

Bevorzugte Monomere E.1.1 sind ausgewählt aus mindestens einem der Monomere Styrol, α-Methylstyrol, Glycidylmethacrylat und Methylmethacrylat, bevorzugte Monomere E.1.2 sind ausgewählt aus mindestens einem der Monomere Acrylnitril, Maleinsäureanhydrid und Methylmethacrylat.

Besonders bevorzugte Monomere sind E.1.1 Styrol und E.1.2 Acrylnitril.

Für die in den Elastomermodifikatoren einzusetztenden Pfropfpolymerisate geeignete Pfropfgrundlagen E.2 sind beispielsweise Dienkautschuke, EP(D)M-Kautschuke, also solche auf Basis Ethylen/Propylen und gegebenenfalls Dien, Acrylat-, Polyurethan-, Silikon-, Chloropren und Ethylen/Vinylacetat-Kautschuke.

Bevorzugte Pfropfgrundlagen E.2 sind Dienkautschuke (z.B. auf Basis Butadien, Isopren etc.) oder Gemische von Dienkautschuken oder Copolymerisate von Dienkautschuken oder deren Gemischen mit weiteren copolymerisierbaren Monomeren (z.B. gemäß E.1.1 und E.1.2), mit der Maßgabe, dass die Glasübergangstemperatur der Komponente E.2 unterhalb <10°C, vorzugsweise <0°C, besonders bevorzugt <-10°C liegt.

Besonders bevorzugt ist als Pfropfgrundlage E.2 reiner Polybutadienkautschuk.

Besonders bevorzugte Polymerisate E sind ABS-Polymerisate (Emulsions-, Masse- und Suspensions-ABS), wie sie z. B. in der DE-A 2 035 390 (=US-A 3 644 574) oder in der DE-A 2 248 242 (=GB-A 1 409 275) bzw. in Ullmann, Enzyklopädie der Technischen Chemie, Bd. 19 (1980), S. 280 ff. beschrieben sind. Der Gelanteil der Pfropfgrundlage E.2 beträgt mindestens 30 Gew.-%, vorzugsweise mindestens 40 Gew.-% (in Toluol gemessen). ABS bedeutet Acrylnitril-Butadien-Styrol-Copolymerisat mit der CAS- Nummer 9003-56-9 und ist ein synthetisches Terpolymer aus den drei unterschiedlichen Monomerarten Acrylnitril, 1,3-Butadien und Styrol. Es gehört zu den amorphen Thermoplasten. Die Mengenverhältnisse können dabei variieren von 15-35 % Acrylnitril, 5-30 % Butadien und 40-60 % Styrol.

Die Elastomermodifikatoren bzw. Pfropfcopolymerisate E werden durch radikalische Polymerisation, z.B. durch Emulsions-, Suspensions-, Lösungs- oder Massepolymerisation, vorzugsweise durch Emulsions- oder Massepolymerisation hergestellt.

Besonders geeignete Pfropfkautschuke sind auch ABS-Polymerisate, die durch Redox-Initiierung mit einem Initiatorsystem aus organischem Hydroperoxid und Ascorbinsäure gemäß US-A 4 937 285 hergestellt werden.

Da bei der Pfropfreaktion die Pfropfmonomeren bekanntlich nicht unbedingt vollständig auf die Pfropfgrundlage aufgepfropft werden, werden erfindungsgemäß unter Pfropfpolymerisaten E auch solche Produkte verstanden, die durch (Co)Polymerisation der Pfropfmonomere in Gegenwart der Pfropfgrundlage gewonnen werden und bei der Aufarbeitung mit anfallen.

Geeignete Acrylatkautschuke basieren auf Propfgrundlagen E.2 die vorzugsweise Polymerisate aus Acrylsäurealkylestern, gegebenenfalls mit bis zu 40 Gew.-%, bezogen auf E.2 anderen polymerisierbaren, ethylenisch ungesättigten Monomeren sind. Zu den bevorzugten polymerisierbaren Acrylsäureestern gehören $C_1$-$C_8$-Alkylester, bevorzugt Methyl-, Ethyl-, Butyl-, n-Octyl- und 2-Ethylhexylester; Halogenalkylester, vorzugsweise Halogen-$C_1$-$C_8$-alkyl-ester, insbesondere bevorzugt Chlorethylacrylat sowie Mischungen dieser Monomeren.

Zur Vernetzung können Monomere mit mehr als einer polymerisierbaren Doppelbindung copolymerisiert werden. Bevorzugte Beispiele für vernetzende Monomere sind Ester ungesättigter Monocarbonsäuren mit 3 bis 8 C-Atomen und ungesättigter einwertiger Alkohole mit 3 bis 12 C-Atomen, oder gesättigter Polyole mit 2 bis 4 OH-Gruppen und 2 bis 20 C-Atomen, wie z.B. Ethylenglykoldimethacrylat, Allylmethacrylat; mehrfach ungesättigte heterocyclische Verbindungen, wie z.B. Trivinyl- und Triallylcyanurat; polyfunktionelle Vinylverbindungen, wie Di- und Trivinylbenzole; aber auch Triallylphosphat und Diallylphthalat.

Bevorzugte vernetzende Monomere sind Allylmethacrylat, Ethylenglykoldimethacrylat, Diallylphthalat und heterocyclische Verbindungen, die mindestens 3 ethylenisch ungesättigte Gruppen aufweisen.

Besonders bevorzugte vernetzende Monomere sind die cyclischen Monomere Triallylcyanurat, Triallylisocyanurat, Triacryloylhexahydro-s-triazin, Triallylbenzole. Die Menge der vernetzten Monomere beträgt vorzugsweise 0,02 bis 5, insbesondere 0,05 bis 2 Gew.-%, bezogen auf die Pfropfgrundlage E.2.

Bei cyclischen vernetzenden Monomeren mit mindestens 3 ethylenisch ungesättigten Gruppen ist es vorteilhaft, die Menge auf unter 1 Gew.-% der Pfropfgrundlage E.2 zu beschränken.

Bevorzugte "andere" polymerisierbare, ethylenisch ungesättigte Monomere, die neben den Acrylsäureestern gegebenenfalls zur Herstellung der Pfropfgrundlage E.2 dienen können, sind beispielsweise Acrylnitril, Styrol, α-Methylstyrol, Acrylamide, Vinyl-$C_1$-$C_6$-alkylether, Methylmethacrylat, Butadien. Bevorzugte Acrylatkautschuke als Pfropfgrundlage E.2 sind Emulsionspolymerisate, die einen Gelgehalt von mindestens 60 Gew.-% aufweisen.

Weitere geeignete Pfropfgrundlagen gemäß E.2 sind Silikonkautschuke mit pfropfaktiven Stellen, wie sie in den DE-A 3 704 657 (= US 4 859 740), DE-A 3 704 655 (= US 4 861 831), DE-A 3 631 540 (= US 4 806 593) und DE-A 3 631 539 (= US 4 812 515) beschrieben werden.

Unabhängig von den Komponente b) und c) können als Additive zusätzliche Füll- und/oder Verstärkungsstoffe

in den erfindungsgemäßen Zusammensetzungen enthalten sein.

Bevorzugt wird aber auch eine Mischung aus zwei oder mehr unterschiedlichen Füllstoffen und/oder Verstärkungsstoffen, insbesondere auf Basis von Glimmer, Silikat, Quarz, Titandioxid - sofern nicht bereits als Pigment eingesetzt -, Wollastonit, Kaolin, amorphe Kieselsäuren, Magnesiumcarbonat, Kreide, Feldspat, Bariumsulfat, Glasfasern, Glaskugeln und/oder faserförmige Füllstoffe und/oder Verstärkungsstoffen auf der Basis von Kohlenstofffasern eingesetzt. Bevorzugt werden mineralische teilchenförmige Füllstoffe auf der Basis von Glimmer, Silikat, Quarz, Wollastonit, Kaolin, amorphe Kieselsäuren, Magnesiumcarbonat, Kreide, Feldspat oder Bariumsulfat eingesetzt. Besonders bevorzugt werden ferner auch nadelförmige mineralische Füllstoffe als Additiv eingesetzt. Unter nadelförmigen mineralischen Füllstoffen wird erfindungsgemäß ein mineralischer Füllstoff mit stark ausgeprägtem nadelförmigen Charakter verstanden. Bevorzugt weist das Mineral ein Länge : Durchmesser - Verhältnis von 2:1 bis 35:1, besonders bevorzugt von 3:1 bis 19:1, am meisten bevorzugt von 4:1 bis 12:1 auf. Die mittlere Teilchengröße d50 der erfindungsgemäß einzusetzenden nadelförmigen Mineralien liegt bevorzugt bei kleiner 20 $\mu$m, besonders bevorzugt bei kleiner 15 $\mu$m, insbesondere bevorzugt bei kleiner 10 $\mu$m bestimmt mit einem CILAS GRANULOMETER in Analogie zur ISO 13320:2009 mittels Laserbeugung.

Wie bereits oben bei der Komponente b) beschrieben, kann in einer bevorzugten Einsatzform auch der als Komponente h) einzusetzende Füllstoff und/oder Verstärkungsstoff oberflächenmodifiziert sein, besonders bevorzugt mit einem Haftvermittler bzw. Haftvermittlersystem, insbesondere bevorzugt auf Epoxidbasis. Die Vorbehandlung ist jedoch nicht unbedingt erforderlich.

In einer besonders bevorzugten Ausführungsform werden als Komponente h) bzw. als Additiv Glasfasern eingesetzt. Gemäß "http://de.wikipedia.org/wiki/Faser-Kunststoff-Verbund" unterscheidet man geschnittene Fasern, auch als Kurzfasern bezeichnet, mit einer Länge im Bereich von 0,1 bis 1 mm, Langfasern mit einer Länge im Bereich von 1 bis 50 mm und Endlosfasern mit einer Länge L > 50 mm. Kurzfasern werden in der Spritzgusstechnik eingesetzt und können direkt mit einem Extruder verarbeitet werden. Langfasern können ebenfalls noch in Extrudern verarbeitet werden. Sie finden im großen Umfang Einsatz beim Faserspritzen. Langfasern werden häufig Duroplasten als Füllstoff zugemischt. Endlosfasern werden als Rovings oder Gewebe in faserverstärkten Kunststoffen eingesetzt. Erzeugnisse mit Endlosfasern erzielen die höchsten Steifigkeits- und Festigkeitswerte. Des Weiteren werden gemahlene Glasfasern angeboten, deren Länge nach der Vermahlung typischerweise im Bereich von 70 bis 200 $\mu$m liegt.

Erfindungsgemäß werden als Komponente h) geschnittene Langglasfasern mit einer Ausgangslänge im Bereich von 1 bis 50 mm, besonders bevorzugt im Bereich von 1 bis 10 mm, ganz besonders bevorzugt im Bereich von 2 bis 7 mm eingesetzt. Die als Komponente h) einzusetzenden Glasfasern können bedingt durch die Verarbeitung zur Formmasse oder zum Erzeugnis in der Formmasse oder im Erzeugnis einen kleineren d97- bzw. d50-Wert aufweisen, als die ursprünglich eingesetzten Glasfasern. So liegt der arithmetische Mittelwert der Glasfaserlänge nach der Verarbeitung häufig nur noch im Bereich von 150 $\mu$m und 300 $\mu$m.

Die Ermittlung der Glasfaserlänge und Glasfaserlängenverteilung erfolgt im Rahmen der vorliegenden Erfindung im Falle verarbeiteter Glasfasern in Analogie zur ISO 22314, welche zunächst eine Veraschung der Proben bei 625 °C vorsieht. Anschließend wird die Asche auf einen mit demineralisiertem Wasser bedeckten Objektträger in einer geeigneten Kristallisierschale gegeben und die Asche ohne Wirkung von mechanischen Kräften im Ultraschallbad verteilt. Der nächste Schritt sieht die Trocknung im Ofen bei 130 °C vor und anschließend erfolgt mit Hilfe von lichtmikroskopischen Aufnahmen die Ermittlung der Glasfaserlänge. Dazu werden von drei Aufnahmen mindestens 100 Glasfasern ausgemessen, so dass insgesamt 300 Glasfasern zur Ermittlung der Länge herangezogen werden. Die Glasfaserlänge kann dabei entweder als arithmetischer Mittelwert $l_n$ nach Gleichung

$$l_n = \frac{1}{n} \cdot \sum_{i}^{n} l_i$$

mit $l_i$ = Länge der iten Faser und n = Anzahl der gemessenen Fasern berechnet und in geeigneter Weise als Histogramm dargestellt oder bei einer angenommenen Normalverteilung der gemessenen Glasfaserlängen $l$ mit Hilfe der Gauß-Funktion nach Gleichung

$$f(l) = \frac{1}{\sqrt{2\pi} \cdot \sigma} \cdot e^{-\frac{1}{2}\left(\frac{l-l_c}{\sigma}\right)^2}$$

Bestimmt werden. Dabei sind $l_c$ und $\sigma$ spezielle Kennwerte der Normalverteilung; $l_c$ ist der mittlere Wert und $\sigma$ die Standardabweichung (siehe: M.Schoßig, Schädigungsmechanismen in faserverstärkten Kunststoffen, 1, 2011, Vieweg und Teubner Verlag, Seite 35, ISBN 978-3-8348-1483-8). Nicht in eine Kunststoffmatrix eingebundene Glasfasern werden hinsichtlich ihrer Längen gemäß obiger Methoden jedoch ohne die Aufbereitung durch Veraschung und Abtrennung von der Asche analysiert.

Die erfindungsgemäß als Komponente h) einzusetzenden Glasfasern (CAS No. 65997-17-3) haben bevorzugt einen Faserdurchmesser im Bereich von 7 bis 18 μm, besonders bevorzugt im Bereich von 9 bis 15 μm, der durch wenigstens eine dem Fachmann zur Verfügung stehende Möglichkeit zu ermitteln ist, insbesondere zu ermitteln durch μ-Röntgen-Computertomographie in Analogie zu "Quantitative Messung von Faserlängen und -verteilung in faserverstärkten Kunststoffteilen mittels μ-Röntgen-Computertomographie", J.KASTNER, et al. DGZfP-Jahrestagung 2007 - Vortrag 47. Die als Komponente d) einzusetzenden Glasfasern werden bevorzugt als Endlosfasern oder als geschnittene oder gemahlene Glasfasern zugesetzt.

Die als Komponente h) einzusetzenden Glasfasern werden als Endlosfasern oder als geschnittene oder gemahlene Glasfasern zugesetzt. Die als Komponente h) einzusetzenden Glasfasern werden bevorzugt mit einem geeigneten Schlichtesystem und einem Haftvermittler bzw. Haftvermittlersystem, besonders bevorzugt auf Silanbasis, ausgerüstet.

Ganz besonders bevorzugte Haftvermittler auf Silanbasis für die Vorbehandlung sind Silanverbindungen der allgemeinen Formel (I)

$$(X-(CH_2)_q)_k-Si-(O-CrH_{2r+1})_{4-k} \qquad (I)$$

in der die Substituenten folgende Bedeutung haben:

X: $NH_2$-, HO-,

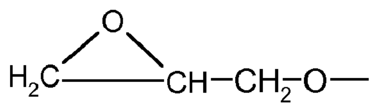

q: eine ganze Zahl von 2 bis 10, bevorzugt 3 bis 4,
r: eine ganze Zahl von 1 bis 5, bevorzugt 1 bis 2,
k: eine ganze Zahl von 1 bis 3, bevorzugt 1.

Insbesondere bevorzugte Haftvermittler sind Silanverbindungen aus der Gruppe Amino-propyltrimethoxysilan, Aminobutyltrimethoxysilan, Aminopropyltriethoxysilan, Aminobutyltriethoxysilan sowie die entsprechenden Silane, welche als Substituent X eine Glycidylgruppe enthalten.

Für die Ausrüstung der Glasfasern werden die Silanverbindungen bevorzugt in Mengen im Bereich von 0,05 bis 2 Gew.-%, besonders bevorzugt im Bereich von 0,25 bis 1,5 Gew.-% und insbesondere im Bereich von 0,5 bis 1 Gew.-% bezogen auf die Glasfasern zur Oberflächenbeschichtung eingesetzt.

Als zusätzliche, von der Komponente b) unterschiedliche Wärmeleitfähigkeitsadditive, kommen bevorzugt Bornitrid oder Aluminiumnitrid infrage. Bevorzugt beträgt das Verhältnis der Boratome zu den Stickstoffatomen im Bornitrid bzw. das Verhältnis der Aluminiumatome zu den Stickstoffatomen im Aluminiumnitrid größer 1. Besonders bevorzugt liegt das Verhältnis der Boratome zu den Stickstoffatomen im Bornitrid im Bereich von 1,05-1,2. Besonders bevorzugt liegt das Verhältnis der Aluminiumatome zu den Stickstoffatomen im Aluminiumnitrid im Bereich von 1,05-1,25. Besonders bevorzugt liegt die mittlere Teilchengröße (d50) des Bornitrids und Aluminiumnitrids im Bereich von 1 μm bis 600 μm, bestimmt mittels dem Fachmann bekannten Debye-Scherrer Verfahrens (siehe: http://de.wikipedia.org/wiki/Debye-Scherrer-Verfahren).

Alle als Komponente h) einzusetzenden teilchenförmigen Füllstoffe können bedingt durch die Verarbeitung zur Formmasse bzw. Formkörper in der Formmasse bzw. im Formkörper einen kleineren d97- bzw. d50-Wert aufweisen, als die ursprünglich eingesetzten Füllstoffe.

In einer bevorzugten Ausführungsform betrifft die vorliegende Erfindung Zusammensetzungen enthaltend PET, triklin pinakoidales Aluminiumsilikat und wenigstens einen Phosphitstabilisator aus der Gruppe Tris(2,4-di-tert-butylphenyl)phosphit, Bis(2,4-di-tert-butylphenyl)pentaerythritoldiphosphit, Bis(2,6-di-tert-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'diylbisphosphonit. In einer besonders bevorzugten Ausführungsform betrifft die vorliegende Erfindung Zusammensetzungen enthaltend PET, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PBT, triklin pinakoidales Aluminiumsilikat und wenigstens einen Phosphitstabilisator aus der Gruppe Tris(2,4-di-tert-butylphenyl)phosphit, Bis(2,4-di-tert-butylphenyl)pentaerythritol-diphosphit, Bis(2,6-di-tert-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PBT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PCT, triklin pinakoidales Aluminiumsilikat und wenigstens einen Phosphitstabilisator aus der Gruppe Tris(2,4-ditert-butylphenyl)phosphit, Bis(2,4-di-tert-butylphenyl)pentaerythritoldiphosphit, Bis(2,6-di-ter-butyl-4-methylphenyl)pentaerythritol-diphosphit, Bis(2,4-dicumyl-phenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PCT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PBT, triklin pinakoidales Aluminiumsilikat und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, PBT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PCT, triklin pinakoidales Aluminiumsilikat und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, PCT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PBT, PCT, triklin pinakoidales Aluminiumsilikat und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PBT, PCT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, triklin pinakoidales Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PBT, triklin pinakoidales Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PBT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PCT, triklin pinakoidales Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PCT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PBT, triklin pinakoidales Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, PBT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PCT, triklin pinakoidales Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, PCT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PBT, PCT, triklin pinakoidales Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PBT, PCT, triklin pinakoidales Aluminiumsilikat, Talkum und Tetrakis(2,4-di-tert-butylphenyl)-1,1-biphenyl-4,4'-diylbisphosphonit.

In einer bevorzugten Ausführungsform betrifft die vorliegende Erfindung Zusammensetzungen enthaltend PET, PBT, PCT, triklin pinakoidales Aluminiumsilikat, Talkum und wenigstens einen Phosphitstabilisator aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-propanediol-phosphit und Tetrakis(2,4-di-tert-butylphenyl)-1,1-biphenyl-4,4'-diylbisphosphonit. In einer besonders bevorzugten Ausführungsform betrifft die vorliegende Erfindung Zusammensetzungen enthaltend PET, PBT, PCT, triklin pinakoidales Aluminiumsilikat, Talkum und Tetrakis(2,4-di-tert-butylphenyl)-1,1-biphenyl-4,4'-diylbisphosphonit.

Die vorliegende Erfindung betrifft aber auch die Verwendung von triklin-pinakoidalem Aluminiumsilikat $Al_2SiO_5$ zur Herstellung elektrisch isolierender, thermisch leitfähiger Erzeugnisse, bevorzugt von Kühlkörpern, insbesondere von Kühlkörpern für Licht emittierende Dioden (LEDs).

Die vorliegende Erfindung betrifft aber auch die Verwendung von triklin pinakoidalem Alumiumsilikat $Al_2SiO_5$ in Kombination mit Talkum zur Herstellung elektrisch isolierender, thermisch leitfähiger Erzeugnisse, bevorzugt von Kühlkörpern, insbesondere von Kühlkörpern für Licht emittierende Dioden (LEDs).

Die vorliegende Erfindung betrifft aber auch die Verwendung von triklin-pinakoidalem Aluminiumsilikat $Al_2SiO_5$ zur Herstellung elektrisch isolierender, thermisch leitfähiger, Polyester basierter Erzeugnisse, bevorzugt von Polyester basierten Kühlkörpern, insbesondere von Polyester basierten Kühlkörpern für Licht emittierende Dioden (LEDs).

Hierfür werden die erfindungsgemäßen Zusammensetzungen in Form von Formmassen einem Spritzguss oder einer Extrusion unterzogen um daraus elektrisch isolierende, thermisch leitfähige Erzeugnisse bevorzugt Kühlkörper, insbesondere Kühlkörper für Licht emittierende Dioden (LEDs), insbesondere auf Basis von Polyester herzustellen.

Erfindungsgemäß für den Spritzguss oder für die Extrusion einzusetzende Formmassen erhält man, indem man die einzelnen Komponenten der erfindungsgemäßen Zusammensetzungen vermischt, zu einem Strang austrägt, bis zur Granulierfähigkeit abkühlt und granuliert. Bevorzugt erfolgt das Vermischen bei Temperaturen im Bereich von 285 bis 310°C in der Schmelze. Insbesondere bevorzugt wird hierzu ein Zweiwellenextruder eingesetzt. In einer bevorzugten Ausführungsform wird das Granulat, das die erfindungsgemäße Zusammensetzung enthält, bei 120°C im Vakuumtrockenschrank für ca. 2h getrocknet, bevor es dem Spritzguss oder einem Extrusionsverfahren zwecks Herstellung von Erzeugnissen unterzogen wird.

Die vorliegende Erfindung betrifft aber auch ein Verfahren zur Herstellung von Erzeugnissen, bevorzugt elektrisch isolierender, thermisch leitfähiger Erzeugnisse, bevorzugt von Kühlkörpern, insbesondere von Kühlkörpern für Licht emittierende Dioden (LEDs), indem das Matrixmaterial als Formmasse enthaltend die erfindungsgemäßen Zusammensetzungen durch Spritzguss oder Extrusion, bevorzugt durch Spritzguss erhalten wird.

Die vorliegende Erfindung betrifft aber auch ein Verfahren zur Verbesserung der Wärmeleitfähigkeit Polyester-basierter Erzeugnisse, dadurch gekennzeichnet, dass man erfindungsgemäße Zusammensetzungen in Form von Formmassen durch Spritzguss oder Extrusion verarbeitet.

Die Verfahren des Spritzgusses sowie der Extrusion thermoplastischer Formmassen sind dem Fachmann bekannt.

Erfindungsgemäße Verfahren zur Herstellung von Erzeugnissen durch Extrusion oder Spritzguss arbeiten bei Schmelzetemperaturen im Bereich von 230 bis 330°C, bevorzugt von 250 bis 300°C sowie gegebenenfalls zusätzlich bei Drücken von maximal 2500 bar, bevorzugt bei Drücken von maximal 2000 bar, besonders bevorzugt bei Drücken von maximal 1500 bar und ganz besonders bevorzugt bei Drücken von maximal 750 bar.

Bei der sequentiellen Coextrusion werden zwei unterschiedliche Materialien in alternierender Folge hintereinander ausgestoßen. Auf diese Weise entsteht ein Vorformling mit in Extrusionsrichtung abschnittsweise unterschiedlicher Materialzusammensetzung. Es können bestimmte Artikelabschnitte durch entsprechende Materialauswahl mit spezifisch erforderlichen Eigenschaften ausgestattet werden, beispielsweise für Artikel mit weichen Enden und hartem Mittelteil oder integrierten weichen Faltenbalg-Bereichen (Thielen, Hartwig, Gust, "Blasformen von Kunststoffhohlkörpern", Carl Hanser Verlag, München 2006, Seite 127-129).

Das Verfahren des Spritzgusses zeichnet sich dadurch aus, dass der Rohstoff, bevorzugt in Granulatform, in einem beheizten zylindrischen Hohlraum aufgeschmolzen (plastifiziert) und als Spritzmasse unter Druck in einen temperierten Hohlraum gespritzt wird. Nach dem Abkühlen (Erstarren) der Masse wird das Spritzgussteil entformt.

Man unterscheidet

1. Plastifizieren / Aufschmelzen

2. Einspritzphase (Füllvorgang)

3. Nachdruckphase (wegen thermischer Kontraktion bei der Kristallisation)

4. Entformen.

Eine Spritzgießmaschine besteht aus einer Schließeinheit, der Spritzeinheit, dem Antrieb und der Steuerung. Zur Schließeinheit gehören feste und bewegliche Aufspannplatten für das Werkzeug, eine Stirnplatte sowie Säulen und Antrieb der beweglichen Werkzeugaufspannplatte. (Kniehebelgelenk oder hydraulische Schließeinheit).

Eine Spritzeinheit umfasst den elektrisch beheizbaren Zylinder, den Antrieb der Schnecke (Motor, Getriebe) und die Hydraulik zum Verschieben der Schnecke und Spritzeinheit. Die Aufgabe der Spritzeinheit besteht darin, das Pulver bzw. das Granulat aufzuschmelzen, zu dosieren, einzuspritzen und nachzudrücken (wegen Kontraktion). Das Problem des Rückflusses der Schmelze innerhalb der Schnecke (Leckströmung) wird durch Rückstromsperren gelöst.

Im Spritzgießwerkzeug wird dann die einströmende Schmelze gelöst, gekühlt und somit das zu fertigende Erzeugnis gefertigt. Notwendig dazu sind immer zwei Werkzeughälften. Beim Spritzguss unterscheidet man folgende Funktionskomplexe:

- Angusssystem
- Formbildende Einsätze
- Entlüftung
- Maschinen- und Kraftaufnahme
- Entformungssystem und Bewegungsübertragung
- Temperierung

Im Gegensatz zum Spritzguss wird bei der Extrusion ein endlos geformter Kunststoffstrang, im Extruder eingesetzt, wobei der Extruder eine Maschine zur Herstellung thermoplastischer Formstücke ist. Man unterscheidet

Einschneckenextruder und Doppelschneckenextruder sowie die jeweiligen Untergruppen
konventioneller Einschneckenextruder, förderwirksamer Einschneckenextruder,
gegenläufiger Doppelschneckenextruder und gleichläufiger Doppelschneckenextruder.

Extrusionsanlagen bestehen aus Extruder, Werkzeug, Nachfolgeeinrichtung, Extrusionsblasformen. Extrusionsanlagen zum Herstellen von Profilen bestehen aus: Extruder, Profil-Werkzeug, Kalibrierung, Kühlstrecke, Raupen- und Rollenabzug, Trennvorrichtung und Kipprinne.

Die vorliegende Erfindung betrifft folglich auch Erzeugnisse, insbesondere wärmeleitfähige Erzeugnisse, erhältlich durch Extrusion, Profil-Extrusion oder Spritzguss der erfindungsgemäßen Zusammensetzungen.

Die vorliegende Erfindung betrifft aber auch Mischungen aus Talkum und triklin pinakoidalem Aluminiumsilikat (CAS No. 1302-76-7).

Die vorliegende Erfindung betrifft bevorzugt ein Verfahren zur Herstellung von Erzeugnissen, bevorzugt wärmeleitfähiger Erzeugnisse, dadurch gekennzeichnet, dass man oben genannte Zusammensetzungen, bevorzugt Zusammensetzungen enthaltend

a) 15 bis 70 Gew.-%, bevorzugt 15 bis 50 Gew.-%, besonders bevorzugt 20 bis 40 Gew.-%, wenigstens eines Polyesters, bevorzugt PBT, PET oder PCT oder Blends aus beliebigen Kombinationen dieser, besonders bevorzugt Blends aus PBT und PET, worin der Anteil an PET bezogen auf die Summe aller enthaltenen Polyester im Bereich von 50 bis 99,9 Gew-% liegt, und

b) 30 bis 85 Gew.-% Aluminiumsilikat, bevorzugt 45 bis 80 Gew.-% Aluminiumsilikat, besonders bevorzugt 55 bis 75 Gew.-% Aluminiumsilikat, wobei die Summe aller Gewichtsprozente 100 ergibt, zu Formmassen, bevorzugt mittels wenigstens eines Misch- oder Knetapparats, verarbeitet und diese einem Spritzguss oder einer Extrusion unterzieht.

Die auf erfindungsgemäße Weise hergestellten Erzeugnisse eignen sich hervorragend zur Herstellung elektrisch isolierender, thermisch leitfähiger Erzeugnisse, bevorzugt von Kühlkörpern, insbesondere von Kühlkörpern für Licht emittierende Dioden (LEDs).

**Beispiele:**

**Edukte:** PBT: Polybutylenterephthalat Pocan® B1300 der Lanxess Deutschland GmbH, Köln, Deutschland

PET: Polyester Chips PET V004 von der Firma Invista, Wichita, USA

Phosphitstabilisator: Hostanox® P-EPQ der Clariant International Ltd., Muttenz, Schweiz

Talkum: Mistron® R10 von Imerys Talc Group, Toulouse, Frankreich (Rio Tinto Group)

Entformungsmittel: Licowax® E der Clariant International Ltd., Muttenz, Schweiz

Kyanit (CAS No. 1302-76-7): $Al_2SiO_5$-Partikel Silatherm® mit Epoxysilanbeschlichtung, Quarzwerke GmbH, Frechen, Deutschland.

Mullit (CAS No. 1302-93-8): Mullit MJ5M, Kyanite Mining Corp., Dillwyn, VA, USA

Aluminiumoxid: Martoxid® MDS der Albemarle Corp. Baton Rouge, Louisiana, USA

Bornitrid: Boronid TCP015FK von ESK, Kempten, Deutschland

**Versuchsdurchführung:**

Zur Herstellung der erfindungemäß beschriebenen Zusammensetzungen wurden die einzelnen Komponenten in einem Zweiwellenextruder (ZSK 26 Mega Compounder der Fa. Coperion Werner & Pfleiderer (Stuttgart, Deutschland mit 3-Loch Düsenplatte und einem Düsenlochdurchmesser von 3mm) bei Temperaturen zwischen 280 und 295°C in der Schmelze vermischt, als Strang ausgetragen, bis zur Granulierfähigkeit abgekühlt und granuliert. Vor weiteren Schritten wurde das Granulat bei 120°C im Vakuumtrockenschrank für ca. 2h getrocknet.

Die Platten und Prüfkörper für die in der Tabelle 1 und Tabelle 2 aufgeführten Untersuchungen wurden auf einer handelsüblichen Spritzgießmaschine bei einer Massetemperatur von 280-290°C und einer Werkzeugtemperatur von 80-120°C verspritzt.

**Messung der Schlagzähigkeit:**

Die Schlagzähigkeit [$kJ/m^2$] der aus den erfindungsgemäßen thermoplastischen Formmassen hergestellten

Erzeugnisse wurden im Schlagversuch nach ISO 180-1 U bei 23°C bestimmt.

**Messung der Randfaserdehnung:**

Die Randfaserdehnung [%] der aus den erfindungsgemäßen thermoplastischen Formmassen hergestellten Erzeugnisse wurden im Biegeversuch nach ISO 178-A bei 23 °C bestimmt.

**Messung der Wärmeleitfähigkeit:**

Die Wärmeleitfähigkeit [kJ / $m^2$] wurde an Platten mit den Maßen 12,7 mm · 12,7 mm · 2 mm nach ISO 22007-4 bestimmt.

**Tabelle 1:**

| | Bsp 1 | Vgl 1 | Vgl 2 |
|---|---|---|---|
| PBT | 49,5 | 49,5 | 49,5 |
| Aluminiumsilikat | 50 | | |
| Aluminiumoxid | | 50 | |
| Bornitrid | | | 50 |
| Entformungsmittel | 0,3 | 0,3 | 0,3 |
| Phosphitstabilisator | 0,1 | 0,1 | 0,1 |
| Talkum | 0,1 | 0,1 | 0,1 |
| | | | |
| Schlagzähigkeit | 36 | 0 | 27 |
| Randfaserdehnung | 3,4 | 1,0 | 3,0 |

Wie aus Tabelle 1 (Bsp. = erfindungsgemäßes Beispiel; Vgl. = Vergleichsbeispiel gemäß dem Stand der Technik) ersichtlich, werden für Erzeugnisse auf Basis der erfindungsgemäßen Zusammensetzungen unter Einsatz von Aluminiumsilikat bei gleichem Füllgrad deutlich bessere mechanische Eigenschaften, insbesondere im Vergleich zu Bornitrid, erhalten. Für einen Vergleich der Wärmeleitfähigkeiten bei höheren Füllgraden wurden deshalb erfindungsgemäße Erzeugnisse mit nur Aluminiumoxid enthaltenden Erzeugnissen verglichen. (Tabelle 2).

**Tabelle 2:**

| | Bsp 2 | Vgl 3 | Vgl 4 |
|---|---|---|---|
| PBT | 34,5 | 34,5 | 34,5 |
| Kyanit | 65 | | |
| Aluminiumoxid | | 65 | |
| Mullit | | | 65 |
| Entformungsmittel | 0,3 | 0,3 | 0,3 |
| Phosphitstabilisator | 0,1 | 0,1 | 0,1 |
| Talkum | 0,1 | 0,1 | 0,1 |
| | | | |
| Schlagzähigkeit [W/mK] | 18 | 10 | 9 |
| Wärmeleitfähigkeit [kJ / $m^2$] | 1,0 | 0,7 | 0,8 |

Der Vergleich von Bsp. 2 und Vgl. 3 zeigt, dass bei Probekörpern erhältlich aus Formmassen erfindungsgemäßer Zusammensetzungen im Vergleich zu Probekörpern aus Formmassen enthaltend Zusammensetzungen mit Aluminiumoxid sowohl bessere Wärmeleitfähigkeiten als auch bessere Schlagzähigkeiten erhalten werden können. Der Vergleich von Bsp. 2 und Vgl. 4 zeigt, dass bei Probekörpern erhältlich aus Formmassen erfindungsgemäßer Zusammensetzungen im Vergleich zu Probekörpern aus Formmassen enthaltend Zusammensetzungen mit Aluminiumsilikaten, welche keine triklin pinakoidale Kristallstruktur aufweisen, sowohl bessere Wärmeleitfähigkeiten als auch bessere Schlagzähigkeiten erhalten werden können. Bei dem in Vgl. 4 eingesetzte Mullit handelt es sich um ein Aluminiumsilikat mit orthorhombisch dipyramidaler Kristallstruktur.

**Patentansprüche**

1. Zusammensetzungen enthaltend

   a) 15 bis 70 Gew.-% wenigstens eines Polyesters,
   b) 29 bis 84 Gew.-% Aluminiumsilikat und gegebenenfalls
   c) 0,01 bis 15 Gew.-% Talkum, wobei die Summe aller Gewichtsprozente stets 100 ergibt.

2. Zusammensetzungen gemäß Anspruch 1, **dadurch gekennzeichnet, dass** diese zusätzlich zu den Komponenten a) bis c) noch

   d) 0,01 bis 5 Gew.-% wenigstens eines Phosphitstabilisators enthalten, wobei die Komponenten a, b, c) soweit reduziert werden, dass die Summe aller Gewichtsprozente stets 100 ergibt.

3. Zusammensetzungen gemäß Anspruch 1 oder 2, **dadurch gekennzeichnet, dass** diese zusätzlich zu den Komponenten a) bis d) oder anstelle von d) noch

   e) 0,01 bis 10 Gew.% wenigstens eines Additives zur Verbesserung der Fließfähigkeit enthalten, wobei die übrigen Komponenten soweit reduziert werden, dass die Summe aller Gewichtsprozente stets 100 ergibt.

4. Zusammensetzungen gemäß einem der Ansprüche 1 bis 3, **dadurch gekennzeichnet, dass** diese zusätzlich zu den Komponenten a) bis d) oder anstelle von d) und/oder e) noch

   f) 0,01 bis 5 Gew.-% wenigstens einer Form von Ruß enthalten, wobei die übrigen Komponenten soweit reduziert werden, dass die Summe aller Gewichtsprozente stets 100 ergibt.

5. Zusammensetzungen gemäß einem der Ansprüche 1 bis 4, **dadurch gekennzeichnet, dass** diese zusätzlich zu den Komponenten a) bis e) oder anstelle der Komponenten d) und/oder e) und/oder f) noch

   g) 0,01 bis 15 Gew.-% wenigstens eines Entformungsmittels enthalten, wobei die übrigen Komponenten soweit reduziert werden, dass die Summe aller Gewichtsprozente stets 100 ergibt.

6. Zusammensetzungen gemäß einem der Ansprüche 1 bis 5, **dadurch gekennzeichnet, dass** diese zusätzlich zu den Komponenten a) bis g) oder anstelle der Komponenten d) und/oder e) und/oder f) und/oder g) noch

   h) 0,01 bis 45 Gew.-% wenigstens eines sonstigen, zu den Komponenten c) bis g) unterschiedlichen Additivs enthalten, wobei die übrigen Komponenten soweit reduziert werden, dass die Summe aller Gewichtsprozente stets 100 ergibt.

7. Zusammensetzungen gemäß Anspruch 6, **dadurch gekennzeichnet, dass** als Additiv Glasfasern eingesetzt werden.

8. Zusammensetzungen gemäß einem der Ansprüche 2 bis 7, **dadurch gekennzeichnet, dass** als Phosphitstabilisator wenigstens einer aus der Gruppe Tris(2,4-ditert-butylphenyl)phosphit, Bis(2,4-di-tert-butylphenyl)pentaerythritol-diphosphit, Bis(2,6-di-ter-butyl-4-methylphenyl)pentaerythritol-diphosphit, Bis(2,4-dicumylphenyl)pentaerythritol-diphosphit, Tris(nonylphenyl)phosphit, (2,4,6-tri-t-butylphenol)2-butyl-2-ethyl-1,3-pro¬pan¬edi¬ol-phosphit und Tetrakis(2,4-di-tert-butylphenyl)-1,1-biphenyl-4,4'-diylbisphosphonit eingesetzt wird.

9. Zusammensetzungen gemäß einem der Ansprüche 1 bis 8, **dadurch gekennzeichnet, dass** als Aluminiumsilikat triklin-pinakoidales Aluminiumsilikat $Al_2SiO_5$ eingesetzt wird.

**10.** Zusammensetzungen gemäß einem der Ansprüche 1 bis 9, **dadurch gekennzeichnet, dass** als Polyester wenigstens ein Polyalkylenterephthalat oder Polycycloalkylenterephthalat, bevorzugt wenigstens ein Polyester der Gruppe Polybutylenterephthalat (PBT), Polyethylenterephthalat (PET), Poly(1,4-cyclohexandimethanolterephthalat) (PCT), oder ein Blend auf Basis von PBT und PET, oder ein Blend auf Basis von PBT und PCT, oder ein Blend auf Basis von PET und PCT oder ein Blend auf Basis von PBT, PET und PCT eingesetzt wird.

**11.** Verwendung von Alumiumsilikat zur Herstellung thermisch leitfähiger Erzeugnisse.

**12.** Verwendung gemäß Anspruch 11, **dadurch gekennzeichnet, dass** als Aluminiumsilikat triklin-pinakoidales Aluminiumsilikat $Al_2SiO_5$ eingesetzt wird.

**13.** Verwendung gemäß einem der Ansprüche 11 oder 12, **dadurch gekennzeichnet, dass** das Aluminiumsilikat in Kombination mit Talkum eingesetzt wird.

**14.** Verwendung gemäß einem der Ansprüche 11 bis 13, **dadurch gekennzeichnet, dass** es sich um Polyester basierte Erzeugnisse handelt.

**15.** Verfahren zur Herstellung von Erzeugnissen, **dadurch gekennzeichnet, dass** man Zusammensetzungen gemäß einem der Ansprüche 1 bis 10 zu Formmassen verarbeitet und diese einem Spritzguss oder einer Extrusion unterzieht.

Europäisches Patentamt
European Patent Office
Office européen des brevets

# EUROPÄISCHER RECHERCHENBERICHT

Nummer der Anmeldung
EP 14 19 4155

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br>Y | US 4 133 797 A (TIRPAK MICHAEL R ET AL) 9. Januar 1979 (1979-01-09)<br>* Spalte 6, Zeile 39 - Zeile 49 *<br>* Anspruch 1 * | 11<br>12,13 | INV.<br>C08K3/34<br>C08L67/00<br>H01L33/64 |
| X<br>Y | DE 596 365 C (CORNING GLASS WORKS) 2. Mai 1934 (1934-05-02)<br>* Seite 1, Zeile 10 - Zeile 12 * | 11<br>12,13 | |
| X<br>Y | US 4 296 021 A (WAMBACH ALLEN D) 20. Oktober 1981 (1981-10-20)<br>* Ansprüche 1-9 * | 1-10,15<br>12,13 | |
| A,D | EP 2 078 736 A1 (TECHNO POLYMER CO LTD [JP]) 15. Juli 2009 (2009-07-15)<br>* Beispiele *<br>* Ansprüche 1,8,9 * | 1-10,14,15 | |
| A,D | DE 10 2011 077668 A1 (TRILUX GMBH & CO KG [DE]) 20. Dezember 2012 (2012-12-20)<br>* das ganze Dokument * | 1-10,14,15 | |

| RECHERCHIERTE SACHGEBIETE (IPC) |
|---|
| C08K<br>C08L<br>H01L |

Der vorliegende Recherchenbericht wurde für alle Patentansprüche erstellt

1

| Recherchenort | Abschlußdatum der Recherche | Prüfer |
|---|---|---|
| München | 13. April 2015 | Kaul-Buchberger, Eva |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR. EP 14 19 4155

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-04-2015

| Im Recherchenbericht angeführtes Patentdokument | Datum der Veröffentlichung | Mitglied(er) der Patentfamilie | Datum der Veröffentlichung |
|---|---|---|---|
| US 4133797 A | 09-01-1979 | DE 2654299 A1 | 08-06-1978 |
| | | FR 2372196 A1 | 23-06-1978 |
| | | GB 1571519 A | 16-07-1980 |
| | | US 4133797 A | 09-01-1979 |
| DE 596365 C | 02-05-1934 | KEINE | |
| US 4296021 A | 20-10-1981 | GB 1569345 A | 11-06-1980 |
| | | JP S5377245 A | 08-07-1978 |
| | | US 4296021 A | 20-10-1981 |
| EP 2078736 A1 | 15-07-2009 | CN 101583670 A | 18-11-2009 |
| | | EP 2078736 A1 | 15-07-2009 |
| | | JP 2008270709 A | 06-11-2008 |
| | | TW 200833758 A | 16-08-2008 |
| | | US 2010072416 A1 | 25-03-2010 |
| | | WO 2008053753 A1 | 08-05-2008 |
| DE 102011077668 A1 | 20-12-2012 | DE 102011077668 A1 | 20-12-2012 |
| | | EP 2535642 A2 | 19-12-2012 |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 102007057533 A1
- DE 102011077668 A1
- US 20120307501 A1
- JP 2007016093 A
- US 20120319031 A1
- DE 10260098 A1
- WO 08043682 A1
- EP 2078736 A1
- US 4133797 A
- DE 596365
- DE 2407674 A
- US 4035958 A
- DE 2407776 A
- DE 2715932 A
- US 4176224 A
- DE 1900270 A
- US 3692744 A
- EP 0528078 A1
- WO 2014001158 A1
- DE 2035390 A
- US 3644574 A
- DE 2248242 A
- GB 1409275 A
- US 4937285 A
- DE 3704657 A
- US 4859740 A
- DE 3704655 A
- US 4861831 A
- DE 3631540 A
- US 4806593 A
- DE 3631539 A
- US 4812515 A


### In der Beschreibung aufgeführte Nicht-Patentliteratur


- **BODO CARLOWITZ.** Tabellarische Übersicht über die Prüfung von Kunststoffen. Giesel-Verlag für Publizität, 1992, 16-17
- *Kunststoffe,* 2000, vol. 90 (9), 116-118
- *Kunststoffe,* 2001, vol. 91 (10), 179-190
- *Advances in Polymer Science,* 1999, vol. 143, 1-34
- **GÄCHTER ; MÜLLER.** Kunststoff-Additive. Hanser-Verlag, 1989
- Plastics Additives Handbook. Hanser-Verlag, 2001
- **ULLMANN.** Enzyklopädie der Technischen Chemie. 1980, vol. 19, 280 ff
- Kunststoffen. Vieweg und Teubner Verlag, 2011, vol. 1, 35
- **J.KASTNER et al.** Quantitative Messung von Faserlängen und -verteilung in faserverstärkten Kunststoffteilen mittels μ-Röntgen-Computertomographie. *DGZfP-Jahrestagung,* 2007
- **THIELEN ; HARTWIG ; GUST.** Blasformen von Kunststoffhohlkörpern. Carl Hanser Verlag, 2006, 127-129